# EUROPEAN PATENT SPECIFICATION

(11) **EP 4 324 095 B1**
(45) Date of publication and mention of the grant of the patent: **27.08.2025**
(21) Application number: 22721703.1
(22) Date of filing: 08.04.2022
(51) Int. Cl.: H03K 17/18, H03K 17/785, G01R 31/327

(54) **DIGITAL OUTPUT MODULE**
DIGITALES AUSGANGSMODUL
MODULE DE SORTIE NUMÉRIQUE

(30) Priority: 16.04.2021 SE 2150474
(43) Date of publication of application: 21.02.2024
(73) Proprietor: Bombardier Transportation GmbH, 10785 Berlin (DE)
(72) Inventor: GUMMERSON, Paul, 722 44 Västerås (SE); MALIS, Ingemar, 726 91 Skultuna (SE)
(74) Representative: Bjerkén Hynell KB
(86) International application number: PCT/EP2022/059358
(87) International publication number: WO 2022/218833

(56) References cited:
- US-A1- 2004 160 131
- US-A1- 2017 272 158
- US-A1- 2020 355 745

## Description

### Technical field

The present disclosure relates to a digital output (DO) module, and to a method of a digital output module. More particularly, the present disclosure relates to digital output modules to be used in various railway applications, and provided with safety capabilities for controlling railway applications, and also for monitoring and avoiding irregularities in operation.

### Background

Digital outputs are widely used in railway applications for general purpose control of external equipment and loads. This imposes integrity requirements on the design of the digital output channels in order to achieve the required safety integrity level (SIL).

The protection of digital outputs which are used for general control functions within the railway vehicle are necessary in order to meet safety integrity requirements.

EP1727157 relates to a safety protection instrumentation system for a nuclear reactor that is constructed by using a digital logic, in which the digital logic includes functional units in which output patterns corresponding to all input logic patterns are verified in advance and a functional module formed by combining the functional units.

US2004/160131 discloses a digital output module to be applied for control purposes in a vehicle.

The object of the present invention is to achieve an improved digital output (DO) module, and a method in relation to the DO module, that meet the safety integrity requirements, and also includes inherent safety monitoring capabilities.

### Summary

The above-mentioned object is achieved by the present invention according to the independent claims.

Preferred embodiments are set forth in the dependent claims.

The function described herein is where a galvanically isolated dedicated power supply is controlled in order to enable or disable the digital outputs. One of the benefits of galvanically isolated or floating digital outputs is that this enables full flexibility in the application of the output, as several digital outputs may be connected in series or in parallel depending on the needs of the respective application.

According to the present invention, a digital output (DO) power control signal is used to control the state of a dedicated power supply which is used to power the driver stage unit of the digital output stage. In order to activate the output both the DO power control signal and a DO control signal must be active. A further signal, denoted DO feedback signal, is used to monitor the state of the output of a DO switch to ensure it is functioning correctly. In the event that a hazard occurs where for example the DO feedback signal is active when it should not be, i.e. indicating that the output stage is active when it should not be, then the safest precaution or reaction to initiate is to remove the power to the DO driver stage. By doing so, nearly all possible failure modes are handled (with the exception of the output transistor itself being short circuit). Thereby, the DO driver stage unit and therefore the DO switch is disabled.

The dedicated power supply can be used to power several digital outputs, e.g. six DOs or twelve DOs, as long as they belong to the same galvanically isolated group.

Preferably, the control signals and the feedback signal are connected to the module via a galvanically isolated connection, e.g. optocouplers.

The digital output module is integrated on a circuit board used to control e.g. motor contactor, separation contactor, line contactor etc. within traction converters of railway applications.

The DO switch is preferably a MOSFET switch which is controlled by the driver signal from the driver stage unit. The switch is inactive in its safe state, i.e. switched off.

The driver unit is configured to receive the DO power control signal and the DO control signal. As mentioned above, a presumption for activation of the switch is that both control signals are in their active states, and when the DO switch is activated, the DO feedback signal is active. The DO power signal is activated before the DO control signal since this enables the DO output stage by activating the power supply circuitry.

According to the invention the DO feedback signal changes state (intentionally) under a finite period of time (e.g. 10ms) following setting the DO power control signal in an active state "1". This facilitates verification of the feedback circuit without the need for dedicated control signals or additional components.

For example, as part of the start-up sequence, the DO power control signal is set in state "1" in order to perform an integrity check on all digital output feedback signals within the same galvanically isolated group. This function tests both states since the initial state of the DO feedback signal is "0", then following activation of the DO power control signal the state changes to being active, i.e. "1", for a finite period (e.g. 10ms) and then returns to logic "0" once again until the DO control signal is activated.

The integrity check of diagnostic test circuitry is very important for safety relevant applications, in order to meet the diagnostic coverage criteria of the safety standards.

One advantage of the test procedure according to the present invention is that it may be implemented without the need for extra circuitry, which improves reliability.

### Brief description of the drawings

Figure 1 is a schematic illustration of a digital output (DO) module according to the present invention.
Figure 2 shows schematic graphs illustrating various signals applied in the DO module.
Figure 3 is a flow diagram illustrating the method according to the present invention.
Figure 4 is a flow diagram illustrating the safety procedure according to the present invention.

### Detailed description

The digital output module, and the method of the digital output module, will now be described in detail with references to the appended figures. Throughout the figures the same, or similar, items have the same reference signs. Moreover, the items and the figures are not necessarily to scale, emphasis instead being placed upon illustrating the principles of the invention.

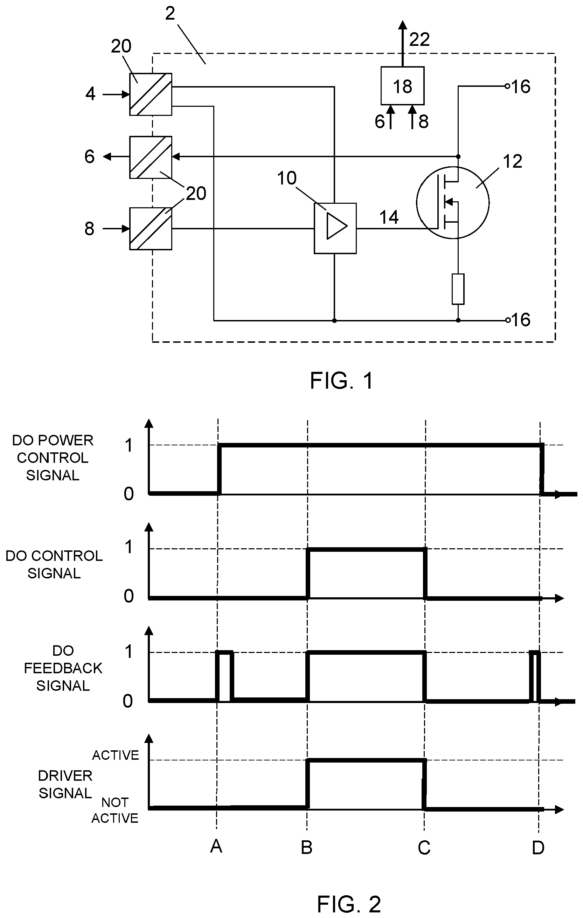

First with references to figure 1, a digital output (DO) module 2 is provided, to be applied for control purposes in a vehicle, such as a railway vehicle.

The DO module 2 comprises two galvanically isolated inputs, configured to receive a DO power control signal 4 and a DO control signal 8, respectively, and one galvanically isolated feedback signal output, configured to provide a DO feedback signal 6.

The DO module 2 further comprises a driver stage unit 10 to provide electrical state control to a DO switch 12 and configured to receive the DO power control signal 4 and the DO control signal 8.

The driver stage unit 10 is further configured to generate an active driver signal 14 to be supplied to the DO switch 12 that is adapted to control the conductive state of a DO output 16 upon receipt of the active driver signal 14. The galvanically isolated feedback signal output is connected to the DO output 16.

The DO module 2 also comprises a control unit 18 that may be embodied by any unit provided with processing and storage capabilities to perform the intended function. The control unit may be one or many units physically integrated in the DO module, but may also be one or many external units, e.g. an external control system.

The DO switch 12 is configured to be in a conductive state and in a non-conductive state in dependence of the driver signal 14 such that the DO switch 12 is in its conductive state when the driver signal 14 is activated and is then configured to control the conductive state of the digital output 16. The driver stage unit 10 is configured to generate an active driver signal 14 only if both the DO power control signal 4 and the DO control signal 8 are in their active states "1" at the same time, and wherein the DO feedback signal 6 then indicates the state of the DO switch 12.

Figure 2 illustrates graphs showing the states "0" or "1" of the DO power control signal, the DO control signal, the DO feedback signal, and the driver signal, being in an active or in a non-active state, generated by the driver stage unit, over time. Four different points of time A, B, C, and D, have been indicated to illustrate various aspects of the function of the DO module.

The DO power control signal, the DO control signal, and the DO feedback signal are electrical signals. Each of these electrical signals is configured to be in either of two voltage levels, where a first level corresponds to the active state, denoted logic "1", and a second voltage level that corresponds to the non-active state, denoted logic "0".

According to an embodiment, the control unit 18 is configured to compare the states of the DO control signal 8 and the DO feedback signal 6, and if those signals are in different states, the control unit 18 is configured to set the DO power control signal 4 in state "0" resulting in that the driver stage unit 10 is set in its non-active state and thus the DO switch(s) 12 powered by DO power is set in a non-conductive state.

In figure 2, this embodiment is illustrated in point of time C, where the DO feedback signal, due to some unknown reason, changes from "1" to "0". The DO control signal therefore changes from state "1" to "0" because those signals are in different digital states, which in turn will set the DO stage unit in non-active state as the DO power control signal and the DO control signal are in different states.

During the time period between B and C in figure 2, both DO power control signal and the DO control signal are "1" resulting in activation of the DO switch, and the DO feedback signal indicates, by also being in state "1" as the DO control signal, that everything works as intended.

In the event that a hazard occurs where for example the DO feedback signal is active when it should not be. This situation is illustrated in figure 2 around point of time D where, for an unknown reason, the DO feedback signal during a short time period changes state from "0" to "1" and then back to "0". In the illustrated example, this results in that the DO power control signal will change state from "1" to "0" in D. Thereby, the DO driver stage unit and therefore the DO switch is disabled.

According to another embodiment, the DO switch 16 is a MOSFET switch. As an alternative, the DO switch may be a relay switch.

According to still another embodiment, the galvanically isolated inputs and output are realized by optocouplers 20.

According to the invention, the control unit 18 is configured to perform a safety test procedure of the DO module 2. The safety test procedure will be described with references to figure 1 and the graphs shown in figure 2, and in particular the state of the signals around point of time A.

The control unit is then configured to check the states of the feedback signal 6 and the DO control signal 8. If both signals are "0", the control unit is further configured to generate a DO power control signal 4 that is "1", and to generate a feedback signal 6 that is "1" during a predetermined test period of e.g. 10 ms. (see figure 2, around point of time A). The duration of the predetermined test period should be long enough to be detected, but short enough not to disturb the function of the DO switch module. Therefore, a suitable length of the test period is in the range of 5 - 25 ms, and preferably 10 ms.

The DO module 2 works as required if the feedback signal 6 is "1" during the predetermined test period, and thereafter changes state to "0", thus returning to ordinary function of indicating conductive state of the DO switch 16.

According to the invention, the control unit 2 is configured to generate an alarm signal 22 if the feedback signal 6 not is "1" during the predetermined test period or does not return to "0" following the predetermined test period. The result of the alarm is that the respective DO module is set in a non-conductive state and diagnostic information provided to the control system indicating the issue. This alarm signal may be used to inactivate the DO power control signal and the DO control signal, i.e. set those signals in state "0", as well as indicating the erroneous state of the DO module to an external control system. The alarm signal is preferably implemented in firmware within a control logic, e.g. an FPGA device.

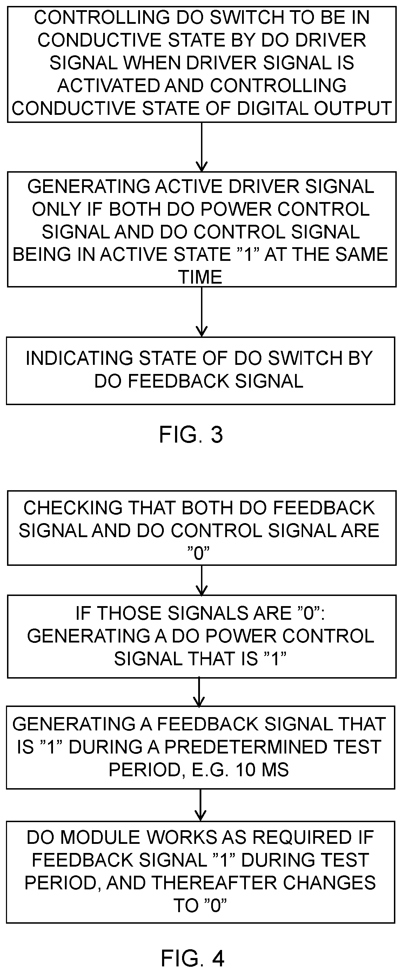

The present invention also relates to a method of controlling the state of a digital output (DO) module to be applied for control purposes in a vehicle, such as a railway vehicle. The method will be presented with references to the flow diagram of figure 3, and further embodiments of the method will be discussed with references to the flow diagram of figure 4.

Thus, the method relates to a method of the DO module that has been described in detail above, and it is herein referred to that description.

All steps of the method are controlled and supervised by the control unit 18 that has been discussed above.

Thus, the DO module comprises two galvanically isolated inputs, configured to receive a DO power control signal 4 and a DO control signal 6, respectively, and one galvanically isolated feedback signal output, configured to provide a DO feedback signal 6. The DO module 2 further comprises a driver stage unit 10 to provide electrical state control to a DO switch 12 and configured to receive the DO power control signal 4 and the DO control signal 8. The driver stage unit 10 is configured to generate an active driver signal 14 to be supplied to the DO switch 12 that is adapted to control the conductive state of a DO output 16 upon receipt of the active driver signal 14, wherein said galvanically isolated feedback signal output is connected to the DO output 16.

The DO module 2 also comprises a control unit 18.

Figure 3 shows a flow diagram illustrating the method that comprises:
- controlling said DO switch to be in in its conductive state by said DO driver signal when said driver signal is activated and then controlling the conductive state of said digital output,
- generating an active driver signal (14) only if both the DO power control signal (4) and the DO control signal (8) are in their active states "1" at the same time, and
- indicating the state of the DO switch (12) by the DO feedback signal.

The method is also illustrated by the graphs shown in figure 2, and in particular the activation of the DO switch during the time period between B and C, where it is clearly shown that a presumption for setting the DO switch in its active state is that the driver signal is in its active state, which only occurs if both the DO power control signal and the DO control signal are in their logic state "1".

In a further embodiment, the method also comprises:
- comparing said DO control signal 8 and said DO feedback signal 6, and if the states of these signals differ, the method further comprises:
- deactivating the DO power control signal 4 resulting in that the driver stage unit 10 is deactivated and thus the DO switch(s) 12 powered by DO power is set in a passive state.

In order to verify the function of the DO module, the method according to the invention is provided, comprising performing a safety test procedure of the DO module. This is illustrated by the flow diagram of figure 4, and also by the graphs shown in figure 2.

Thus, the method comprises:
checking that both the feedback signal 6 and the DO control signal 8 are "0", and if those signals are "0":
generating a DO power control signal 4 that is "1", the DO power control signal is preferably controlled by an external control system and shall be activated in the initial stages of operation,
generating a feedback signal 6 that is "1" during a predetermined test period of e.g. 10 ms.

The DO module 2 works as required if the feedback signal 6 is "1" during the predetermined test period, and thereafter changes state to "0", thus returning to ordinary function of indicating the conductive state of the DO switch 16.

The method comprises generating an alarm signal 22 if the feedback signal 6 not is "1" during the predetermined test period or does not return to "0" following the predetermined test period.

The present invention also relates to a railway vehicle, e.g. a train, comprising one or many digital output (DO) modules as described above.

The present invention is not limited to the above-described preferred embodiments.

Various alternatives, modifications and equivalents may be used. Therefore, the above embodiments should not be taken as limiting the scope of the invention, which is defined by the appending claims.

## Claims

1. A digital output (DO) module (2) to be applied for control purposes in a vehicle, such as a railway vehicle, and comprising two galvanically isolated inputs, configured to receive a DO power control signal (4) and a DO control signal (8), respectively, and one galvanically isolated feedback signal output, configured to provide a DO feedback signal (6), wherein each of these electrical signals (4, 6, 8) is either on a first voltage level representing an active state being denoted "1" or on a second voltage level representing a non-active state being denoted "0", the DO module (2) further comprises a driver stage unit (10) to provide electrical state control to a DO switch (12) being configured to be in a conductive state or a non-conductive state, the driver stage unit (10) is configured to receive said DO power control signal (4) and said DO control signal (8), and to generate a driver signal (14) to be supplied to the DO switch (12) that is adapted to control the conductive state of a DO output (16) upon receipt of said driver signal (14), wherein said galvanically isolated feedback signal output is connected to said DO output (16), the DO module (2) also comprises a control unit (18), said DO switch (12) is configured to be in the conductive state or in the non-conductive state in dependence of the driver signal (14) such that the DO switch (12) is in its conductive state when said driver signal (14) is activated and is then configured to control the conductive state of said digital output (16), wherein said driver stage unit (10) is configured to generate the driver signal (14) only if both the DO power control signal (4) and the DO control signal (8) are in their active states "1" at the same time, and wherein said DO feedback signal (6) indicates the state of the DO switch (12), **characterized in that** said control unit (18) is configured to perform a safety test procedure of the DO module (2), wherein the control unit is configured to check the states of the feedback signal (6) and the DO control signal (8), and if both signals are "0", the control unit is further configured to generate a DO power control signal (4) that is "1", and to generate a feedback signal (6) that is "1" during a predetermined test period of e.g. 10 ms,
wherein said DO module (2) works as required if said feedback signal (6) is "1" during said predetermined test period, and thereafter changes state to "0" being returning to its ordinary function of indicating the conductive state of the DO switch (12), and wherein said control unit (18) is configured to generate an alarm signal (22) if said feedback signal (6) not is "1" during said predetermined test period or does not return to "0" following said predetermined test period.

2. The DO module (2) according to claim 1, wherein said control unit (18) is configured to compare said DO control signal (8) and said DO feedback signal (6), and if the comparison indicates that those signals are in different states, the control unit (18) is configured to set the DO power control signal (4) in its non-active state "0" resulting in that the driver stage unit (10) is set in a non-active state and thus the DO switch(s) (12) is set in a non-conductive state.

3. The DO module (2) according to claim 1 or 2, wherein said DO switch (12) is a MOSFET switch.

4. The DO module (2) according to any of claims 1-3, wherein said galvanically isolated inputs and output are realized by optocouplers (20).

5. A method of controlling the state of a digital output (DO) module (2) to be applied for control purposes in a vehicle, such as a railway vehicle, the DO module comprises two galvanically isolated inputs, configured to receive a DO power control signal (4) and a DO control signal (8), respectively, and one galvanically isolated feedback signal output, configured to provide a DO feedback signal (6), wherein each of these electrical signals (4, 6, 8) may be either in a first voltage level representing an active state being denoted "1" or a second voltage level representing a non-active state being denoted "0", the DO module (2) further comprises a driver stage unit (10) to provide electrical state control to a DO switch (12) being configured to be in a conductive state or a non-conductive state, the driver stage unit (10) is configured to receive said DO power control signal (4) and said DO control signal (8), and to generate a driver signal (14) to be supplied to the DO switch (12) that is adapted to control the conductive state of a DO output (16) upon receipt of said driver signal (14), wherein said galvanically isolated feedback signal output is connected to said DO output (16), the DO module (2) also comprises a control unit (18), wherein said method comprises:
- controlling said DO switch to be in in its conductive state by said DO driver signal when said driver signal is activated and then controlling the conductive state of said digital output,
- generating the driver signal (14) only if both the DO power control signal (4) and the DO control signal (8) are in their active states "1" at the same time, and
- indicating the state of the DO switch (12) by the DO feedback signal,
**characterized in that** the method further comprises performing a safety test procedure of the DO module (2), comprising:
checking that both the feedback signal (6) and the DO control signal (8) are "0", and if those signals are "0":
generating a DO power control signal (4) that is "1",
generating a feedback signal (6) that is "1" during a predetermined test period of e.g. 10 ms,
wherein said DO module (2) works as required if said feedback signal (6) is "1" during said predetermined test period, and thereafter changes state to "0", thus returning to its ordinary function of indicating the conductive state of the DO switch (12), and that the method further comprising generating an alarm signal (22) if said feedback signal (6) not is "1" during said predetermined test period or does not return to "0" following said predetermined test period.

6. The method according to claim 5, wherein the method comprises:
- comparing said DO control signal (8) and said DO feedback signal (6), and if those signals are in different states, the method further comprises:
- setting the DO power control signal (4) in its non-active state "0" resulting in that the driver stage unit (10) is set in a non-active state and thus the DO switch(s) (12) is set in a non-conductive state.

7. A railway vehicle comprising at least one digital output (DO) modules, according to any of claims 1-4 and/or the at least one digital output (DO) modules is controlled using the method of controlling the state of a digital output (DO) module according to any of claims 5-6.

## Patentansprüche

1. Digitales Ausgangsmodul (DO) (2), das für Steuerungszwecke in einem Fahrzeug, wie beispielsweise einem Schienenfahrzeug, eingesetzt wird und zwei galvanisch isolierte Eingänge umfasst, die so konfiguriert sind, dass sie ein DO-Leistungssteuersignal (4) beziehungsweise ein DO-Steuersignal (8) empfangen, und einen galvanisch isolierten Rückkopplungssignalausgang, der so konfiguriert ist, dass er ein DO-Rückkopplungssignal (6) bereitstellt, wobei jedes dieser elektrischen Signale (4, 6, 8) entweder auf einem ersten Spannungspegel liegt, der einen aktiven Zustand darstellt, der mit "1" bezeichnet wird, oder auf einem zweiten Spannungspegel liegt, der einen nicht-aktiven Zustand darstellt, der mit "0" bezeichnet wird, wobei das DO-Modul (2) ferner eine Treiberstufeneinheit (10) umfasst, um eine elektrische Zustandssteuerung für einen DO-Schalter (12) bereitzustellen, der die Treiberstufeneinheit (10) so konfiguriert ist, dass sie sich in einem leitenden Zustand oder einem nicht-leitenden Zustand befindet, die Treiberstufeneinheit (10) so konfiguriert ist, dass sie das DO-Leistungssteuersignal (4) und das DO-Steuersignal (8) empfängt und ein Treibersignal (14) erzeugt, das dem DO-Schalter (12) zugeführt wird, der so angepasst ist, dass er den leitenden Zustand eines DO-Ausgangs (16) bei Empfang des Treibersignals (14) steuert, wobei der galvanisch isolierte Rückkopplungssignalausgang mit dem DO-Ausgang verbunden ist (16), das DO-Modul (2) auch eine Steuereinheit (18) umfasst, der DO-Schalter (12) so konfiguriert ist, dass er sich in Abhängigkeit von dem Treibersignal (14) in dem leitenden Zustand oder in dem nicht-leitenden Zustand befindet, so dass der DO-Schalter (12) sich in seinem leitenden Zustand befindet, wenn das Treibersignal (14) aktiviert wird, und dann so konfiguriert ist, dass er den leitenden Zustand des digitalen Ausgangs (16) steuert, wobei die Treiberstufeneinheit (10) so konfiguriert ist, dass sie das Treibersignal (14) nur erzeugt, wenn sowohl das DO-Leistungssteuersignal (4) als auch das DO-Steuersignal (8) gleichzeitig in ihrem aktiven Zustand "1" sind, und wobei das DO-Rückkopplungssignal (6) den Zustand des DO-Schalters (12) anzeigt,
**dadurch gekennzeichnet, dass** die Steuereinheit (18) so konfiguriert ist, dass sie eine Sicherheitstestprozedur des DO-Moduls (2) durchführt, wobei die Steuereinheit so konfiguriert ist, dass sie die Zustände des Rückkopplungssignals (6) und der DO-Steuerung überprüft Signal (8), und wenn beide Signale "0" sind, ist die Steuereinheit ferner so konfiguriert, dass sie ein DO-Leistungssteuersignal (4) erzeugt, das "1" ist, und dass sie ein Rückkopplungssignal (6) erzeugt, das "1" ist, während einer vorbestimmten Prüfzeit von z.B. 10 ms,
wobei das DO-Modul (2) wie erforderlich arbeitet, wenn das Rückkopplungssignal (6) während der vorbestimmten Prüfzeit "1" ist, und danach den Zustand auf "0" ändert, indem es zu seinem gewöhnliche Funktion, den leitenden Zustand des DO-Schalters (12) anzuzeigen, und wobei die Steuereinheit (18) so konfiguriert ist, dass sie ein Alarmsignal (22) erzeugt, wenn das Rückkopplungssignal (6) während der vorbestimmten Prüfzeit nicht "1" ist oder im Anschluss an die vorbestimmte Prüfzeit nicht auf "0" zurückgeht.

2. DO-Modul (2) nach Anspruch 1, wobei die Steuereinheit (18) so konfiguriert ist, dass sie das DO-Steuersignal (8) und das DO-Rückkopplungssignal (6) vergleicht, und wenn der Vergleich anzeigt, dass sich diese Signale in unterschiedlichen Zuständen befinden, ist die Steuereinheit (18) so konfiguriert, dass sie das DO-Leistungssteuersignal (4) in seinen nicht aktiven Zustand "0" versetzt, was dazu führt, dass die Treiberstufeneinheit (10) in einen nicht aktiven Zustand versetzt wird und somit der/die DO-Schalter (12) in einen nicht leitenden Zustand versetzt wird/werden.

3. DO-Modul (2) nach Anspruch 1 oder 2, wobei der DO-Schalter (12) ein MOSFET-Schalter ist.

4. DO-Modul (2) nach einem der Ansprüche 1-3, wobei die galvanisch getrennten Ein- und Ausgänge durch Optokoppler (20) realisiert sind.

5. Verfahren zur Steuerung des Zustands eines digitalen Ausgangsmoduls (DO-Moduls) (2), das für Steuerzwecke in einem Fahrzeug, wie beispielsweise einem Schienenfahrzeug, eingesetzt wird, wobei das DO-Modul zwei galvanisch isolierte Eingänge, die so konfiguriert sind, dass sie ein DO-Leistungssteuersignal (4) bzw. ein DO-Steuersignal (8) empfangen, und einen galvanisch isolierten Rückkopplungausgang (8), der so konfiguriert ist, dass er ein DO-Rückkopplungssignal (6) bereitstellt, wobei jedes dieser elektrischen Signale (4, 6, 8) entweder in einem ersten Spannungspegel, der einen aktiven Zustand darstellt, der mit "1" bezeichnet wird, oder in einem zweiten Spannungspegel, der einen nicht-aktiven Zustand darstellt, der mit "0" bezeichnet wird, sein kann, wobei das DO-Modul (2) ferner eine Treiberstufeneinheit (10) umfasst, um eine elektrische Zustandssteuerung für einen DO-Schalter (12) bereitzustellen, der so konfiguriert ist, dass er in einem leitenden Zustand oder einem nicht-leitenden Zustand ist, wobei die Treiberstufeneinheit (10) so konfiguriert ist, dass sie das DO-Leistungssteuersignal (4) und das DO-Steuersignal (8) empfängt und ein Treibersignal (14) erzeugt, das dem DO-Schalter (12) zugeführt wird, der so ausgelegt ist, dass er den leitenden Zustand eines DO-Ausgangs (16) bei Empfang des Treibersignals (14) steuert, wobei der galvanisch isolierte Rückkopplungssignalausgang mit dem DO-Ausgang (16) verbunden ist, wobei das DO-Modul (2) außerdem eine Steuereinheit (18) umfasst, wobei das Verfahren umfasst:
- Steuern des DO-Schalters, so dass er sich in seinem leitenden Zustand befindet, durch das DO-Treibersignal, wenn das Treibersignal aktiviert ist, und dann Steuern des leitenden Zustands der digitalen Ausgabe,
- Erzeugung der Treibersignal (14) nur dann, wenn sowohl das DO-Leistungssteuersignal (4) als auch das DO-Steuersignal (8) gleichzeitig in ihrem aktiven Zustand "1" sind, und
- die Anzeige des Zustands des DO-Schalters (12) durch das DO-Rückkopplungssignal,
**gekennzeichnet dadurch, dass** das Verfahren ferner die Durchführung eines Sicherheitstestverfahrens des DO-Moduls (2) umfasst, das Folgendes umfasst:
Überprüfen, ob sowohl das Rückkopplungssignal (6) als auch das DO-Steuersignal (8) "0" sind, und wenn diese Signale "0" sind,
Erzeugen eines DO-Leistungssteuerungssignals (4), das "1" ist,
Erzeugen eines Rückmeldesignal (6), das während einer vorbestimmten Prüfzeit von z. B. 10 ms "1" ist,
wobei das DO-Modul (2) wie erforderlich arbeitet, wenn das Rückkopplungssignal (6) während der vorbestimmten Prüfzeit "1" ist und danach seinen Zustand auf "0" ändert, wodurch es zu seiner gewöhnlichen Funktion der Anzeige des leitenden Zustands des DO-Schalters (12) zurückkehrt, und dass die Verfahren, das ferner das Erzeugen eines Alarmsignals (22) umfasst, wenn das Rückkopplungssignal (6) während der vorbestimmten Prüfzeit nicht "1" ist oder nach der vorbestimmten Prüfzeit nicht auf "0" zurückkehrt.

6. Verfahren nach Anspruch 5, wobei das Verfahren umfasst:
- Vergleichen des DO-Steuersignals (8) und des DO-Rückkopplungssignals (6), und wenn diese Signale in unterschiedlichen Zuständen sind, umfasst das Verfahren ferner.
- Setzen des DO-Leistungssteuersignals (4) in seinen nicht-aktiven Zustand "0", was dazu führt, dass die Treiberstufeneinheit (10) in einen nicht-aktiven Zustand versetzt wird und somit der/die DO-Schalter (12) in einen nicht-leitenden Zustand versetzt wird/werden.

7. Ein Schienenfahrzeug mit mindestens einem digitalen Ausgangsmodul (DO), nach einem der Ansprüche 1 bis 4 und/oder das mindestens eine digitale Ausgangsmodul (DO-Modul) wird unter Verwendung des Verfahrens zur Steuerung des Zustands eines digitalen Ausgangsmoduls (DO-Moduls) gesteuert nach einem der Ansprüche 5-6.

## Revendications

1. Module (2) de sortie numérique (DO) destiné à être utilisé à des fins de commande dans un véhicule, tel qu'un véhicule ferroviaire, et comprenant deux entrées isolées galvaniquement configurées pour recevoir un signal de commande de puissance DO (4) et un signal de commande DO (8), respectivement, et une sortie de signal de rétroaction isolée galvaniquement configurée pour fournir un signal de rétroaction DO (6), dans lequel chacun de ces signaux électriques (4, 6, 8) est soit sur un premier niveau de tension représentant un état actif noté « 1 » soit sur un second niveau de tension représentant un état non actif noté « 0 », le module DO (2) comprend en outre une unité d'étage d'attaque (10) pour fournir une commande d'état électrique à un commutateur DO (12) qui est configuré pour être dans un état conducteur ou un état non conducteur, l'unité d'étage d'attaque (10) est configurée pour recevoir ledit signal de commande de puissance DO (4) et ledit signal de commande DO (8), et pour générer un signal d'attaque (14) à alimenter vers le commutateur DO (12) qui est adapté pour commander l'état conducteur d'une sortie DO (16) lors de la réception dudit signal d'attaque (14), dans lequel ladite sortie de signal de rétroaction isolée galvaniquement est connectée à ladite sortie DO (16), le module DO (2) comprend également une unité de commande (18), ledit commutateur DO (12) est configuré pour être dans l'état conducteur ou dans l'état non conducteur en fonction du signal d'attaque (14) de sorte que le commutateur DO (12) est dans son état conducteur lorsque ledit signal d'attaque (14) est activé et est ensuite configuré pour commander l'état conducteur de ladite sortie numérique (16), dans lequel ladite unité d'étage d'attaque (10) est configurée pour générer le signal d'attaque (14) uniquement si à la fois le signal de commande de puissance DO (4) et le signal de commande DO (8) sont dans leurs états actifs « 1 » en même temps, et dans lequel ledit signal de rétroaction DO (6) indique l'état du commutateur DO (12), **caractérisé en ce que** ladite unité de commande (18) est configurée pour réaliser une procédure de test de sécurité du module DO (2), dans lequel l'unité de commande est configurée pour vérifier les états du signal de rétroaction (6) et du signal de commande DO (8), et si les deux signaux sont à « 0 », l'unité de commande est en outre configurée pour générer un signal de commande de puissance DO (4) qui est « 1 », et pour générer un signal de rétroaction (6) qui est « 1 » pendant une période de test prédéterminée, par exemple, de 10 ms,
dans lequel ledit module DO (2) fonctionne comme requis si ledit signal de rétroaction (6) est « 1 » pendant ladite période de test prédéterminée, et passe ensuite à l'état à « 0 » en revenant à sa fonction ordinaire d'indication de l'état conducteur du commutateur DO (12), et dans lequel ladite unité de commande (18) est configurée pour générer un signal d'alarme (22) si ledit signal de rétroaction (6) n'est pas « 1 » pendant ladite période de test prédéterminée ou ne revient pas à « 0 » après ladite période de test prédéterminée.

2. Module DO (2) selon la revendication 1, dans lequel ladite unité de commande (18) est configurée pour comparer ledit signal de commande DO (8) et ledit signal de rétroaction DO (6), et si la comparaison indique que ces signaux sont dans des états différents, l'unité de commande (18) est configurée pour régler le signal de commande de puissance DO (4) dans son état non actif « 0 » résultant en ce que l'unité d'étage d'attaque (10) est réglée dans un état non actif et donc le/les commutateur(s) DO (12) sont réglés dans un état non conducteur.

3. Module DO (2) selon la revendication 1 ou 2, dans lequel ledit commutateur DO (12) est un commutateur MOSFET.

4. Module DO (2) selon l'une quelconque des revendications 1 à 3, dans lequel lesdites entrée et sortie isolées galvaniquement sont réalisées par des optocoupleurs (20).

5. Procédé de commande de l'état d'un module de sortie numérique (DO) (2) à appliquer à des fins de commande dans un véhicule, tel qu'un véhicule ferroviaire, le module DO comprend deux entrées isolées galvaniquement configurées pour recevoir un signal de commande de puissance DO (4) et un signal de commande DO (8), respectivement, et une sortie de signal de rétroaction isolée galvaniquement configurée pour fournir un signal de rétroaction DO (6), dans lequel chacun de ces signaux électriques (4, 6, 8) peut être soit dans un premier niveau de tension représentant un état actif noté « 1 » soit dans un second niveau de tension représentant un état non actif noté « 0 », le module DO (2) comprend en outre une unité d'étage d'attaque (10) pour fournir une commande d'état électrique à un commutateur DO (12) qui est configuré pour être dans un état conducteur ou un état non conducteur, l'unité d'étage d'attaque (10) est configurée pour recevoir ledit signal de commande de puissance DO (4) et ledit signal de commande DO (8), et pour générer un signal d'attaque (14) à alimenter vers le commutateur DO (12) qui est adapté pour commander l'état conducteur d'une sortie DO (16) lors de la réception dudit signal d'attaque (14), dans lequel ladite sortie de signal de rétroaction isolée galvaniquement est connectée à ladite sortie DO (16), le module DO (2) comprend également une unité de commande (18), dans lequel ledit procédé comprend :
- la commande dudit commutateur DO pour être dans son état conducteur par ledit signal d'attaque DO lorsque ledit signal d'attaque est activé et ensuite la commande de l'état conducteur de ladite sortie numérique,
- la génération du signal d'attaque (14) uniquement si à la fois le signal de commande de puissance DO (4) et le signal de commande DO (8) sont dans leurs états actifs « 1 » en même temps, et
- l'indication de l'état du commutateur DO (12) par le signal de rétroaction DO,
**caractérisé en ce que** le procédé comprend en outre la réalisation d'une procédure de test de sécurité du module DO (2), comprenant :
la vérification qu'à la fois le signal de rétroaction (6) et le signal de commande DO (8) sont tous deux à « 0 », et si ces signaux sont à « 0 » :
la génération d'un signal de commande de puissance DO (4) qui est « 1 »,
la génération d'un signal de rétroaction (6) qui est « 1 » pendant une période de test prédéterminée, par exemple, de 10 ms,
dans lequel ledit module DO (2) fonctionne comme requis si ledit signal de rétroaction (6) est « 1 » pendant ladite période de test prédéterminée, et passe ensuite à l'état « 0 », revenant ainsi à sa fonction ordinaire d'indication de l'état conducteur du commutateur DO (12), et **en ce que** le procédé comprend en outre la génération d'un signal d'alarme (22) si ledit signal de rétroaction (6) n'est pas « 1 » pendant ladite période de test prédéterminée ou ne revient pas à « 0 » après ladite période de test prédéterminée.

6. Procédé selon la revendication 5, dans lequel le procédé comprend :
- la comparaison dudit signal de commande DO (8) et dudit signal de rétroaction DO (6), et si ces signaux sont dans des états différents, le procédé comprend en outre :
- le réglage du signal de commande de puissance DO (4) dans son état non actif « 0 » résultant en ce que l'unité d'étage d'attaque (10) est réglée dans un état non actif et ainsi le/les commutateur(s) DO (12) sont réglés dans un état non conducteur.

7. Véhicule ferroviaire comprenant au moins un module de sortie numérique (DO), selon l'une quelconque des revendications 1 à 4 et/ou l'au moins un module de sortie numérique (DO) est commandé en utilisant le procédé de commande de l'état d'un module de sortie numérique (DO) selon l'une quelconque des revendications 5 et 6.
